# EUROPÄISCHE PATENTANMELDUNG

(11) **EP 3 153 663 A1**
(43) Veröffentlichungstag der Anmeldung: **12.04.2017**
(21) Anmeldenummer: 16192644.9
(22) Anmeldetag: 06.10.2016
(51) Int. Cl.: F01D 5/14, G06F 17/50

(54) **SCHAUFEL FÜR EINE STRÖMUNGSMASCHINE, TURBOFANTRIEBWERK UND EIN VERFAHREN ZUR HERSTELLUNG EINER SCHAUFEL**

(30) Priorität: 08.10.2015 DE 102015219530
(71) Anmelder: Rolls-Royce Deutschland Ltd & Co KG, 15827 Blankenfelde-Mahlow (DE)
(72) Erfinder: TIEDEMANN, Christian Dr., 12307 Berlin (DE); ALLNOCH, Carsten, 13355 Berlin (DE)
(74) Vertreter: Maikowski & Ninnemann Patentanwälte Partnerschaft mbB

(57) **Zusammenfassung**

Die Erfindung betrifft eine Schaufel (1) für eine Strömungsmaschine, die eine Schaufelaußenhaut (10) und eine Schaufelinnenstruktur (20) aufweist, **dadurch gekennzeichnet,** dass die Schaufelinnenstruktur (20) eine Mehrzahl von länglichen Stützelementen (40, 41, 44-57) aufweist, die sich zumindest abschnittsweise schräg zur radialen Richtung der Schaufel (1) erstrecken, wobei die Stützelemente (40, 41, 44-57) miteinander und/oder mit der Schaufelaußenhaut (10) verbunden und die Bereiche zwischen den Stützelementen (40, 41, 44-57) als Hohlräume (30-35) ausgebildet sind.

## Beschreibung

Die Erfindung betrifft eine Schaufel für eine Strömungsmaschine gemäß dem Oberbegriff des Patentanspruchs 1, ein Turbofantriebwerk gemäß Patentanspruch 12 und ein Verfahren zur Herstellung einer Schaufel gemäß dem Patentanspruch 13.

Es ist bekannt, Schaufeln einer Strömungsmaschine als Hohlschaufeln auszubilden, die einen strukturierten Schaufelinnenraum mit Hohlstrukturen umfassen.

So beschreibt die EP 2 584 146 A1 eine Laufschaufel für eine Strömungsmaschine, deren Schaufelinnenraum durch wandartige Querstege strukturiert wird. Es ist in Ausführungsbeispielen vorgesehen, dass solche wandartigen Querstege einander kreuzen oder zwischen der Saugseite und der Druckseite der Schaufel hin und her laufen, wobei im Querschnitt dreieckige oder viereckige Hohlstrukturen entstehen. Die einzelnen Hohlstrukturen erstrecken sich dabei durchgehend in radialer Richtung vom Schaufelfuß bis zur Schaufelspitze.

Die EP 1 995 411 A2 beschreibt eine Laufschaufel, die Trennwände aufweist, die sich zwischen der Saugseite und der Druckseite der Schaufel hin und her erstrecken und dabei im Querschnitt dreieckförmige Hohlräume bilden. In einem anderen Ausführungsbeispiel werden quadratische Hohlräume gebildet. Auch hier ist vorgesehen, dass die Hohlräume sich in radialer Richtung durchgehend vom Schaufelfuß bis zur Schaufelspitze erstrecken.

Es besteht ein Bedarf, Schaufeln für eine Strömungsmaschine im Hinblick auf Gewicht und Stabilität weitergehend zu optimieren.

Es besteht die Aufgabe, eine Schaufel für eine Strömungsmaschine bereitzustellen, die sich bei geringem Gewicht durch eine hohe Festigkeit und Stabilität auszeichnet. Des Weiteren soll ein Verfahren zum Herstellen einer solchen Schaufel bereitgestellt werden.

Diese Aufgabe wird durch eine Schaufel mit den Merkmalen des Patentanspruchs 1, ein Turbofantriebwerk gemäß Patentanspruch 12 und ein Verfahren zur Herstellung einer Schaufel mit den Merkmalen des Patentanspruchs 13 gelöst.

Danach zeichnet sich die Lösung durch eine Schaufelinnenstruktur aus, die eine Mehrzahl von länglichen Stützelementen aufweist, die zumindest abschnittsweise (d.h. entlang ihrer gesamten Länge oder entlang zumindest eines Abschnitts) sich schräg zur radialen Richtung der Schaufel erstrecken. Die Stützelemente sind miteinander und/oder mit der Schaufelaußenhaut verbunden. Die Bereiche zwischen den Stützelementen sind als Hohlräume ausgebildet.

Die Lösung zeichnet sich durch die Bereitstellung einer Schaufelinnenstruktur aus, die nicht durch gerade oder geradlinige Wände oder Stege gebildet ist, sondern die zumindest teilweise aus schräg verlaufenden und in ihrer Dicke sich verändernden Stützelementen besteht. Die Stützelemente bilden dabei ein unregelmäßiges und asymmetrisches dreidimensionales Gitter. Dass die Stützelemente zumindest abschnittsweise sich schräg zur radialen Richtung der Schaufel erstrecken, bedeutet unter anderem, dass die Stützelemente in radialer Richtung der Schaufel nicht durchgängig ausgebildet sind, d.h. sich nicht durchgängig in radialer Richtung zwischen Schaufelfuß und Schaufelspitze erstrecken. Durch die schräge Ausrichtung wird des Weiteren ermöglicht, dass die Stützelemente miteinander zur Bildung eines dreidimensionalen asymmetrischen Gitters verbunden sind. Die beschriebene Lösung ermöglicht es, Form und Verlauf der Stützelemente beanspruchungsgerecht auszubilden, d.h. die Stützelemente in den Bereichen des Schaufelinneren vorzusehen, in denen im Betrieb der Schaufel eine hohe mechanische Belastung vorliegt. Die frei im Raum ausgebildete Stützstruktur stellt kein ebenes Fachwerk dar, sondern es werden alle Raumwinkel genutzt.

Damit wird die Einsparung von Material ermöglicht bzw. die Bereitstellung eines hohen Hohlraumanteils bei gleichzeitiger hoher Festigkeit und struktureller Stabilität der hier beschriebenen Schaufel.

In einer Ausführungsform weisen die Stützelemente eine entlang ihres Verlaufs sich verändernde Querschnittsfläche auf. Dass die Stützelemente eine entlang ihres Verlaufs sich verändernde Querschnittsfläche aufweisen, bedeutet unter anderem, dass die Form und/oder der Umfang der Querschnittsfläche der Stützelemente sich entlang des länglichen Verlaufs der Stützelemente verändert. Beispielsweise können Verjüngungen oder Verdickungen realisiert sein.

Gemäß einer Ausgestaltung besitzen die Stützelemente zumindest abschnittsweise einen gebogenen Verlauf. Dies bedeutet unter anderem, dass zumindest einige der Stützelemente zumindest abschnittsweise gekrümmt verlaufen. Die Stützelemente sind somit nicht gerade bzw. geradlinig ausgebildet, sondern verlaufen zumindest in Teilbereichen gekrümmt.

Gemäß einer weiteren Ausgestaltung sind die Stützelemente zumindest abschnittsweise rippenartig ausgebildet. Es werden rippenartige Stützelemente eingesetzt, die im Querschnitt eine ovale Form besitzen, d.h. der Umfang der Querschnittsfläche wird durch eine geschlossene Kurve gebildet, die glatt und konvex ist.

Gemäß einer weiteren Ausführungsform bilden die Stützelemente zumindest abschnittsweise einen Steg aus, der sich zwischen der Saugseite und der Druckseite der Schaufel erstreckt. Insofern können die Stützelemente auch Wandbereiche ausbilden, die aber anders als plane Wände sich zumindest abschnittsweise schräg zur radialen Richtung der Schaufel erstrecken und die eine entlang ihres Verlaufs sich verändernde Querschnittsfläche aufweisen.

Weiter kann vorgesehen sein, dass zumindest zwei der Stützelemente sich in einem Verzweigungsbereich zu einem Stützelement vereinen. Ebenso kann vorgesehen sein, dass ein Stützelement sich in einem Verzweigungsbereich in zwei Stützelemente aufteilt. Dies umfasst, dass von einem Stützelement ein weiteres Stützelement abzweigt. Hierdurch werden Vernetzungen zwischen den einzelnen Stützelementen ermöglicht, mit denen insgesamt ein unregelmäßiges und asymmetrisches dreidimensionales Gitter aus den Stützelementen bereitstellbar ist.

In einem solchen Verzweigungsbereich können z.B. zwischen 3 und 100, insbesondere zwischen 3 und 50, ganz insbesondere zwischen 3 und 10 Stützelemente zusammenkommen.

In einer Ausführungsform sind entlang der Stützelemente zwischen 0,1 und 5, insbesondere zwischen 0,1 und 3, ganz insbesondere zwischen 0,1 und 0,5 Verbindungsbereiche pro mm Lauflänge der Stützelemente angeordnet.

In einer zusätzlichen oder alternativen Ausführungsform wird die Laufrichtung der Stützelemente als der kürzeste Weg von der Vorderkante der Schaufel zur Hinterkante der Schaufel oder als der kürzeste Weg von der Saugseite zur Druckseite der Schaufel gemessen.

In einer Ausführungsform beträgt der mittlere Hohlraumanteil der Schaufelinnenstruktur zwischen 65 und 80 %, insbesondere zwischen 65 und 75%, ganz insbesondere 70%. Dieser Mittelwert ist entlang einer Schnittfläche entlang der Mittellinie der Schaufel zu bestimmen.

Eine weitere Ausgestaltung sieht vor, dass mehrere der Stützelemente sich zumindest abschnittsweise zu flächigen Stützstrukturen vereinigen. Beispielsweise kann vorgesehen sein, dass mehrere Stützelemente in einem flächigen bzw. tellerartigen Strukturbereich enden bzw. von einem solchen ausgehen. So können insbesondere zwischen 3 und 100, insbesondere zwischen 3 und 50, ganz insbesondere zwischen 3 und 10 Stützelemente sich zumindest abschnittsweise zu flächigen Wandbereichen vereinigen.

Alternativ oder zusätzlich ist es möglich, dass die Stützelemente ein unregelmäßiges und asymmetrisches dreidimensionales Gitter bilden.

Eine weitere Ausgestaltung sieht vor, dass die Stützelemente eine Mehrzahl von Hohlräumen ausbilden. Diese Hohlräume können geschlossen ausgebildet sein, d.h. sie sind vollständig vom Material der Stützelemente umgeben. Sie können alternativ jedoch auch zumindest teilweise offen ausgebildet sein, d.h. sie werden von Stützelementen begrenzt, sind dabei jedoch mit weiteren Hohlräumen verbunden. In beiden Fällen ist vorgesehen, dass die einzelnen Hohlräume unterschiedliche Formen und Größen aufweisen und nicht im Hinblick auf Form und Größe einheitlich sind.

Insbesondere sieht eine Ausgestaltung vor, dass die Hohlräume bei Betrachtung einer Schnittansicht der Schaufel eine Varianz im Hinblick auf den Durchmesser der Hohlräume aufweisen. Als Durchmesser der Hohlräume wird dabei der größte Abstand zwischen zwei Punkten auf einer Kurve betrachtet, die in dem betrachteten Schnitt den Rand des Hohlraums bildet. Dabei ist vorgesehen, dass mindestens zwei der Hohlräume sich in Bezug auf den so definierten Durchmesser um mindestens den Faktor 5 unterscheiden. In weiteren Ausgestaltungen kann vorgesehen sein, dass mindestens zwei der Hohlräume sich im Hinblick auf den genannten Durchmesser um mindestens den Faktor 10, um mindestens den Faktor 20 oder um mindestens den Faktor 50 unterscheiden. Die Lösung sieht gemäß dieser Ausgestaltung somit Hohlräume in der Schaufel mit stark voneinander abweichendem Durchmesser bzw. Größe vor.

Die Hohlräume werden in der betrachteten Schnittansicht der Schaufel in einer vorteilhaften Ausgestaltung durch eine glatte und konvexe Begrenzungskurve begrenzt. Die Begrenzung der Hohlräume wird demensprechend in der betrachteten Schnittansicht durch ein Oval gebildet.

Die genannte Schnittansicht, in der die Hohlräume die genannten Durchmesser unterschiedlicher Größe aufweisen, kann eine Schnittansicht senkrecht zur radialen Erstreckungsrichtung der Schaufel, eine Schnittansicht senkrecht zur axialen Erstreckungsrichtung der Schaufel oder eine Schnittansicht senkrecht zur Umfangsrichtung der Schaufel sein. Dabei kann ebenfalls vorgesehen sein, dass die Hohlräume zumindest in zwei aufeinander senkrecht stehenden Schnittansichten der Schaufel die genannten Durchmesser unterschiedlicher Größe aufweisen.

Es wird darauf hingewiesen, dass die hier beschriebenen Schaufeln eine Rotorschaufel oder eine Statorschaufel eines Verdichters oder einer Turbine sein kann. Eine beispielhafte Anwendung der Erfindung liegt in der Implementierung von Schaufeln in einem Turbofantriebwerk, beispielsweise in einem Fan oder in einer Rotorstufe oder einer Statorstufe eines Verdichters oder einer Turbine. Es ist aber auch möglich, dass die Schaufeln in einer stationären Turbomaschine, wie z.B. einer Gasturbine angeordnet sind.

Aufgrund der Form der Stützstrukturen kann sich, wie bereits erwähnt, ein unregelmäßiges und asymmetrisches dreidimensionales Gitter aus Stützelementen ergeben. Dabei ist in einer Ausgestaltung vorgesehen, dass keine zwei Stützelemente der Schaufel existieren, die eine identische dreidimensionale Form aufweisen, d.h. die gleiche Form und die gleiche Orientierung im Raum besitzen.

Eine weitere Ausführungsform sieht vor, dass der Anteil der Hohlräume am Gesamtvolumen der Schaufelinnenstruktur in radialer Richtung nach außen zunimmt, was mit einer Abnahme der Dicke bzw. des Umfangs und/oder der Anzahl der Stützelemente in radialer Richtung nach außen korrespondiert. Dies ist insofern vorteilhaft, als die radial äußeren Bereiche der Schaufel insbesondere bei Laufschaufeln eine stärkere mechanische Belastung erfahren und dementsprechend eine Materialreduzierung im radial äußeren Bereich einer Schaufel besonders vorteilhaft ist. Die Richtung "radial" bezieht sich ebenso wie die Richtungen "axial" und "in Umfangsrichtung" hier auf eine in einer Strömungsmaschine angeordnete Schaufel, wobei Zylinderkoordinaten betrachtet werden und die axiale Richtung gleich oder im Wesentlichen gleich der Achse der Strömungsmaschine ist.

Eine weitere Ausgestaltung sieht vor, dass zumindest einige der Hohlräume länglich ausgebildet und dazu geeignet sind, Kühlluft zu transportieren. Dabei kann vorgesehen sein, dass zumindest einige der Hohlräume Kühlöffnungen in der Schaufelaußenhaut bilden. Hierdurch ist es möglich, beispielsweise durch den Schaufelfuß eingeleitete Kühlluft zur Kühlung der Schaufel einzusetzen und ggf. über die genannten Kühlöffnungen in der Schaufelaußenhaut abzulassen. Die Möglichkeit einer Kühlung ist dabei nicht nur für Turbinenschaufeln, sondern auch für Verdichterschaufeln eröffnet.

Eine weitere Ausgestaltung sieht vor, dass aufgrund des gitterförmigen Aufbaus der Schaufelinnenstruktur der Innenraum der Schaufel insgesamt mit Kühlluft befüllbar ist, d.h. die Kühlluft wird in sämtliche oder in eine Vielzahl der bei dieser Ausgestaltung miteinander verbundenen Hohlräume geleitet.

Die hier betrachtete Schaufel ist im Hinblick auf die Schaufelaußenhaut in üblicher Weise aufgebaut. Sie weist insbesondere eine Vorderkante, eine Hinterkante, eine Saugseite, eine Druckseite, einen Schaufelfuß zur Befestigung der Schaufel und eine Schaufelspitze auf. Statt eines Schaufelfußes kann auch ein anderes integrales Befestigungselement vorgesehen sein.

Die hier beschriebene Schaufel ist durch ein generatives Fertigungsverfahren wie beispielsweise 3D-Drucken herstellbar. Ein beispielhaftes Verfahren zur Herstellung einer Schaufel umfasst dabei die folgenden Schritte:
- Erstellen eines Vollmaterialmodells der Schaufel,
- iteratives Entfernen von Materialbereichen des Vollmaterialmodells auf der Basis eines Finite-Elemente-Verfahrens, wobei bei jeder Iteration mindestens ein Materialbereich des Vollmaterialmodells entfernt wird, der eine geringe Belastung beim Betrieb der Schaufel in einer Strömungsmaschine erfahren würde, wobei das iterative Verfahren bis zum Erreichen einer definierten Bedingung durchgeführt wird,
- Erstellen einer 3D-Blaupause des Modells, das bis Erreichen der definierten Bedingung durch das iterative Verfahren bereitgestellt worden ist, und
- Herstellen der Schaufel auf der Basis der erstellten 3D-Blaupause mittels eines generativen Fertigungsverfahrens (z.B. 3D-Drucken oder "Direct Laser Deposition").

Wie erwähnt, wird beim iterativen Entfernen von Materialbereichen des Vollmaterialmodells auf der Basis eines Finite-Elemente-Verfahrens bei jeder Iteration mindestens ein Materialbereich des Vollmaterialmodells entfernt, der eine geringe Belastung beim Betrieb der Schaufel in einer Strömungsmaschine erfahren würde. Gemäß einer Ausgestaltung werden bei jeder Iteration solche Materialbereiche entfernt, die beim Betrieb der Schaufel in einer Strömungsmaschine die niedrigeste Belastung erfahren würden.

Weiter kann vorgesehen sein, dass das genannte Verfahren wie folgt weitergehend spezifiziert ist:
- nach Erstellen eines Vollmaterialmodells wird eine Vernetzung des Vollmaterialmodells mit definierter Auflösung bereitgestellt,
- im Rahmen eines ersten Iterationsprozesses werden Startbedingungen festgelegt,
- im Rahmen eines zweiten Iterationsprozesses werden:
   ∘ Materialbereiche beliebiger Form und Größe an unterschiedlichen Positionen im Vollmaterialmodell gemäß den Startbedingungen entfernt,
   o Belastungen des modifizierten Modelles im Betrieb bestimmt,
   o erfolgt ein Vergleich der resultierenden Belastungen mit gültigen Akzeptanzkriterien,
   ∘ wenn die Akzeptanzkriterien erfüllt sind, erfolgt eine weitere Entfernung von Material und der Start einer neuen Iteration unter Verwendung des modifizierten Modells,
   ∘ wenn die Akzeptanzkriterien nicht erfüllt sind, wird das Modell der letzten Iteration, die diese Kriterien erfüllte, verwendet und erfolgt eine Beendigung des zweiten Iterationsprozesses,
- im Rahmen des ersten Iterationsprozesses erfolgt eine Modifikation oder Festlegung neuer Startbedingungen für einen erneuten zweiten Iterationsprozess,
- erfolgt ein Vergleich der Ergebnisse von mindestens zwei verschiedenen zweiten Iterationsprozessen,
- wird der erste Iterationsprozess beendet, wenn vorbestimmte Bedingungen erreicht sind und/oder keine Verbesserung der Ergebnisse im Hinblick auf die Akzeptanzkriterien mehr erfolgt, und
- wird eine 3D-Blaupause für das am Ende des zweiten Iterationsprozesses bereitgestellte Modell erstellt.

Die Erfindung betrifft des Weiteren jede Schaufel, die nach dem genannten Verfahren hergestellt ist.

Die Erfindung wird nachfolgend unter Bezugnahme auf die Figuren der Zeichnung anhand mehrerer Ausführungsbeispiele näher erläutert. Es zeigen:
- Figur 1: ein Ausführungsbeispiel einer Schaufel, wobei ein erster Profilschnitt in einer ersten radialen Höhe und ein zweiter Profilschnitt in einer zweiten radialen Höhe der Schaufel dargestellt sind;
- Figur 1A: eine Erläuterung von Details der Figur 1;
- Figur 2: eine Schnittansicht der Schaufel der Figur 1 entlang der Linie A-A der Figur 1; und
- Figur 3: ein weiteres Ausführungsbeispiel einer Schaufel unter Darstellung einer schematischen 3D-Darstellung des Schaufelinnenraums.

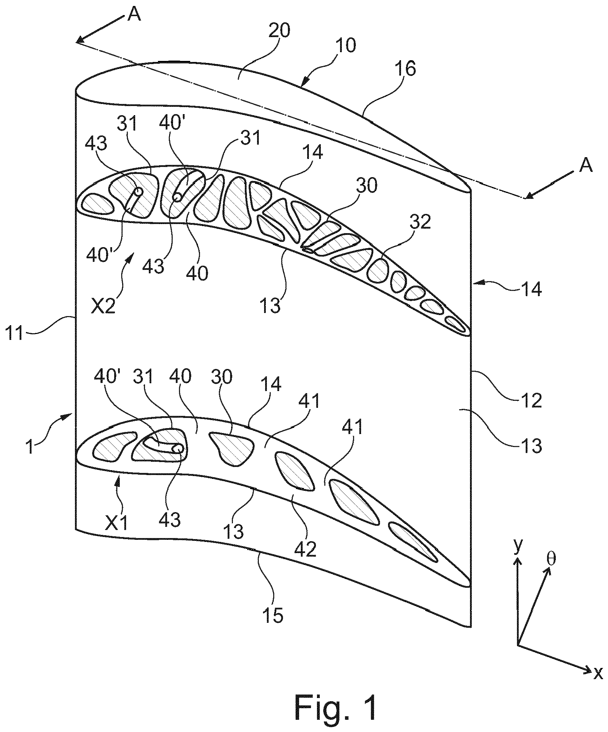

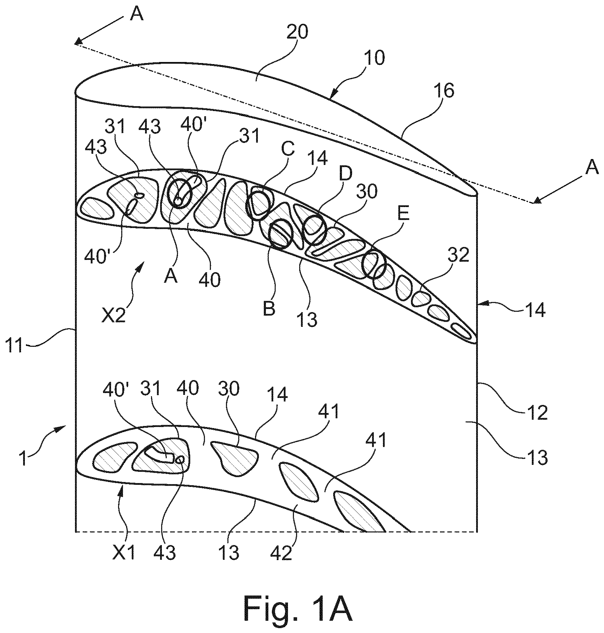

Die Figur 1 zeigt eine Schaufel 1 einer Strömungsmaschine, bei der es sich beispielsweise um ein Turbofantriebwerk für ein Flugzeug handelt. Die schematisch dargestellte Schaufel 1 stellt beispielsweise eine Fanschaufel, eine Rotor- oder eine Statorschaufel eines Verdichters oder eine Rotor- oder eine Statorschaufel einer Turbine dar. Die Verwendung der hier beschriebenen Schaufeln ist aber nicht auf Flugzeugtriebwerke beschränkt. Sie können auch in stationären Turbomaschinen verwendet werden.

Die Schaufel 1 umfasst eine Schaufelaußenhaut 10 und eine Schaufelinnenstruktur 20. Die Schaufelaußenhaut 10 umfasst eine Vorderkante 11, eine Hinterkante 12, eine Druckseite 13 und eine Saugseite 14. Die Schaufelinnenstruktur 20 umfasst Stützelemente 40 und Hohlräume 30-32.

Jeder Punkt auf der Schaufelaußenhaut 10 und der Schaufelinnenstruktur 20 kann in einem zylindrischen Koordinatensystem dargestellt werden, das die Koordinaten x, r und θ aufweist. Dabei gibt x die axiale Richtung, r die radiale Richtung und θ (aus der Zeichenebene heraus) den Winkel in Umfangsrichtung an. Der Koordinatenursprung kann beispielsweise so definiert sein, dass die x-Achse identisch mit der Rotationsachse der Schaufel 1 ist. Von dieser x-Achse ausgehend zeigt die radiale Richtung radial nach außen. Dabei gibt der Wert von r die Höhe der Schaufel 1 an.

Die Schaufel 1 erstreckt sich in radialer Richtung zwischen einem Schaufelfuß 15 und einer Schaufelspitze 16. Der Schaufelfuß 15 ist dabei lediglich schematisch als Unterkante des Schaufelblattes dargestellt. Typischerweise umfasst die Schaufel in ihrem Fußbereich ein integrales Befestigungselement zur Befestigung der Schaufel beispielsweise an einer rotierenden Scheibe. Grundsätzlich kann die Schaufel dabei auch einteilig mit einer solchen Scheibe in BLISK-Bauweise oder in BLING-Bauweise ausgebildet sein. Die Schaufelspitze 16 kann mit einem Deckband (nicht dargestellt) versehen sein.

Mehrere Schaufeln der dargestellten Art bilden eine Schaufelreihe eines Rotors oder eines Stators.

Die Figur 1 zeigt zwei Profilschnitte X1, X2 der Schaufel 1 in zwei unterschiedlichen radialen Höhen, wobei die Profilschnitte senkrecht zur radialen Richtung r der Schaufel verlaufen.

Die Schaufel 1 zeichnet sich durch eine Schaufelinnenstruktur aus, die eine Mehrzahl von länglichen Stützelementen 40 aufweist. Die Stützelemente 40 sind miteinander und/oder mit der Schaufelaußenhaut 10 verbunden und bilden ein unregelmäßiges und asymmetrisches dreidimensionales Gitter, das den Schaufelinnenraum 20 ausfüllt. Die Bereiche zwischen den Stützelementen 40 sind als Hohlräume 30-32 ausgebildet.

Die Stützelemente 40 verlaufen nicht gerade oder geradlinig, stellen keine planen Wände oder Stege dar und erstrecken sich nicht durchgehend in radialer Richtung zwischen dem Schaufelfuß 15 und der Schaufelspitze 16. Stattdessen handelt es sich um Stützelemente, die eine entlang ihres Verlaufs sich verändernde Querschnittsfläche aufweisen und dementsprechend entlang ihrer Längsrichtung in Dicke bzw. Umfang sich verändern. Gleichzeitig verlaufen sie zumindest abschnittsweise schräg zur radialen Richtung r der Schaufel 1, wobei sich insgesamt eine Gitterstruktur ergibt.

Die Stützelemente 40 können auch als rippenartige Elemente bezeichnet werden. Sie können zumindest abschnittsweise einen gebogenen Verlauf besitzen, d.h. bezogen auf ihre Längsrichtung gekrümmt ausgebildet sein.

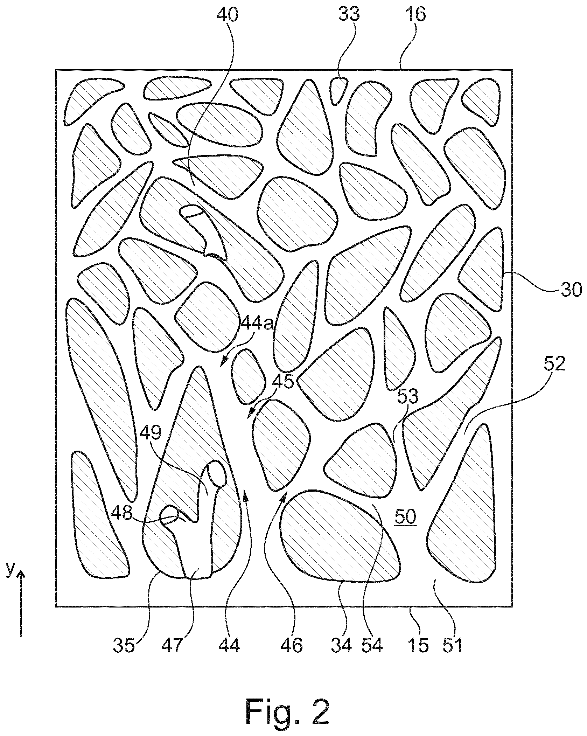

Die Stützelemente 40 können verschiedene Ausgestaltungen aufweisen und Strukturen bilden, von denen einige nachfolgend beispielhaft beschrieben sind. Dabei wird zusätzlich Bezug genommen auf die Schnittdarstellung der Figur 2, die einen Schnitt entlang der Linie A-A der Figur 1 und damit senkrecht zur Umfangsrichtung θ der Schaufel der Figur 1 darstellt.

Gemäß einer Ausgestaltung bilden die Stützelemente Stege 41 (vgl. Figur 1), die sich zwischen der Saugseite 14 und Druckseite 13 der Schaufel 1 durchgehend erstrecken. Die Stege 41 schließen dabei zusammen mit Materialbereichen 42, die an die Schaufelaußenhaut 10 grenzen, Hohlräume 30 ein. Es wird jedoch darauf hingewiesen, dass diese Hohlräume 30 sich in radialer Richtung keineswegs durchgehend bis zur Schaufelspitze 16 erstrecken, sondern stattdessen in radialer Richtung eine Vielzahl von Hohlräumen 30 vorgesehen ist, die in ihrer radialen Ausdehnung jeweils begrenzt sind, wie in der Figur 2 dargestellt ist. Dementsprechend verlaufen die Stege 41 auch nicht oder nicht ausschließlich in radialer Richtung r, sondern erstrecken sich schräg zur radialen Richtung r, wobei sie typischerweise zumindest abschnittsweise einen gebogenen Verlauf besitzen. Der gebogene Verlauf der Stützelemente 40, 41 ist in der Figur 1 schematisch dadurch dargestellt, dass in einigen der Hohlräume 31 Stützelemente 40' dargestellt sind, die in die Hohlräume 31 hinein ragen, wobei der dargestellte Schnitt eine Querschnittsfläche 43 dieser Stützelemente 40' freilegt.

Weiter wird darauf hingewiesen, dass die dargestellten Hohlräume zwar vollständig von Material der Stützelemente 40 und von dem an die Schaufelaußenhaut 10 angrenzenden Material 42 begrenzt sein können, so dass es sich um geschlossene Hohlstrukturen handelt, ein solcher Aufbau jedoch nicht zwingend ist. Es können alternativ teilweise oder vollständig Hohlstrukturen realisiert sein, die miteinander verbunden sind und nur in der jeweiligen Schnittdarstellung (z.B. den Profilschnitten X1, X2 der Figur 1) geschlossen sind.

In der Figur 1A, die einen Ausschnitt der Fig. 1 darstellt, sind fünf Details A bis E darstellt, das asymmetrische, unregelmäßige dreidimensionale Gitter näher beschreiben.

Die Details A und B zeigen durchdringende Stützelemente, die frei im Raum ausgerichtet sind, alle Raumwinkel sind vorhanden. Die Details C und D zeigen dreidimensionale Knoten der Stützelemente, d.h. drei sich frei im Raum orientierte Stützelemente verbinden sich zu Knoten, wobei auch hier die Raumwinkel beliebig sind. Im Detail E ist ein Stützelement dargestellt, das sich frei von der Saug- zur Druckseite ausdehnt. Es sind wieder alle Raumwinkel möglich. Es ist kein weiterer Knoten für Stützelemente erforderlich.

Die Figur 2 zeigt mehrere beispielhafte Verläufe von länglichen Stützelementen. So ist ein Stützelement 44 dargestellt, das sich angrenzend an den Schaufelfuß 15 ausbildet und sich bis zu seinem Ende 44a verjüngt und dementsprechend entlang seines Verlaufs eine abnehmende Querschnittsfläche aufweist. Gleichzeitig verläuft das Stützelement 44 schräg zur radialen Richtung r der Schaufel.

Weiter ist als typisch zu erkennen, dass von dem betrachteten Stützelement 44 zwei weitere Stützelemente 45, 46 seitlich abzweigen.

Weiter zeigt die Figur 2 eine beispielhafte Ausgestaltung, bei der sich ein Stützelement in einem Verzweigungsbereich in zwei Stützelemente aufteilt. So teilt sich das in den Hohlraum 35 herein ragende Stützelement 47 in zwei Stützelemente 48, 49 auf.

Eine weitere typische Struktur stellt ein tellerartiger, flächiger Bereich 50 dar, zu dem sich eine Mehrzahl von Stützelementen 51-54 vereinigen bzw. von dem diese Stützelemente ausgehen.

Es liegt insgesamt eine vernetzte Struktur der einzelnen Stützelemente 40, 41, 44-54 vor, wobei sich Stützelemente aufteilen oder vereinigen, Abzweigungen und tellerartige Bereiche bilden können. Die vernetzte Struktur umfasst eine Vielzahl von Verbindungsstellen zwischen den Stützelementen 40, 41, 44-54 untereinander und zwischen den Stützelementen 40, 41, 44-54 und der Schaufelaußenhaut 10 (bzw. an die Schaufelaußenhaut 10 angrenzenden, dort einen Rand bildenden Materialbereichen 42). Die Stützelemente 40, 41, 44-54 verlaufen dabei zumindest abschnittsweise schräg zur radialen Richtung der Schaufel 1 und können zumindest abschnittsweise gekrümmt und dabei rippenartig ausgebildet sein. Entlang ihres Verlaufs ändert sich ihre Querschnittsfläche.

Als Anfangspunkt eines länglichen Stützelementes 40, 41, 44-54 kann beispielsweise der Abzweigungspunkt oder die Gabelungsstelle eines Stützelementes angesehen werden (vgl. Stützelemente 45, 46, 48, 49 der Figur 2) oder der Beginn der Ausformung eines Stützelementes angrenzend an die Schaufelaußenhaut 10 (vgl. Stützelement 44 der Figur 2) oder der Beginn der Ausformung eines Stützelementes angrenzend an einen wandartigen Bereich (z.B. beginnt das Stützelement 54 dort, wo es den tellerartigen Bereich 50 verlässt). Als Endpunkt eines Stützelementes kann beispielsweise ein Punkt oder Bereich angesehen werden, an dem das Stützelement an der Schaufelaußenhaut 10 endet oder an dem das Stützelement sich in einem Verzweigungsbereich in zwei Stützelemente aufteilt (z.B. endet das Stützelement 47 der Figur 2 an der Gabelungsstelle zu den Stützelementen 48, 49) oder an dem ein Stützelement in einem Vereinigungsbereich endet.

Die beschriebene Schaufelinnenstruktur 20 führt auch zu einer bestimmten Art von Hohlräumen, auf die im Folgenden eingegangen wird.

Aufgrund der beschriebenen Gitterstruktur unterscheiden sich die einzelnen Hohlräume in Form und Größe. Dabei weisen die Hohlräume eine starke Streuung im Hinblick auf ihre Größe auf, wobei mindestens zwei der Hohlräume sich in einer Schnittansicht der Schaufel (z.B. in den Profilschnitten X1, X2 der Figur 1 oder im Längsschnitt der Figur 2) um mindestens den Faktor 5 im Durchmesser unterscheiden. Beispielsweise unterscheiden sich in der Figur 2 die Hohlräume 33 und 34 in der dargestellten Schnittansicht im Hinblick auf ihren Durchmesser um mindestens den Faktor 5. Als Durchmesser wird dabei der größte Abstand zwischen zwei Punkten auf der Kurve, die durch den Schnitt gebildet wird, angesehen. Die Unterschiede in der Größe können noch stärker ausgebildet sein, wobei sich die betrachteten Durchmesser um einen größeren Faktor als den Faktor 5, z.B. um den Faktor 10 oder 20 unterscheiden können.

Weiter ist erkennbar, dass die Hohlräume 30 bis 35 in der jeweils betrachteten Schnittansicht eine glatte und konvexe Begrenzungskurve aufweisen.

Die genannten Eigenschaften der Hohlräume können sowohl in einer Schnittansicht senkrecht zur radialen Erstreckungsrichtung (z.B. den Schnittansichten X1, X2 der Figur 1) als auch in einer Schnittansicht senkrecht zur Umfangsrichtung der Schaufel (entsprechend der Schnittansicht der Figur 2) realisiert sein.

In der Figur 1 ist weiter zu erkennen, dass der Anteil der Hohlräume am Gesamtvolumen der Schaufelinnenstruktur 20 in radialer Richtung nach außen zunimmt. Die Schaufel 1 umfasst nach außen hin somit immer weniger Schaufelmaterial und ist dementsprechend in radialer Richtung zunehmend leichter ausgebildet. Dies ist insbesondere bei einem Vergleich der Profilschnitte X1, X2 der Figur 1 erkennbar.

Wenn man die mittlere Hohlraumdichte im Schnitt der Fig. 2 bestimmt, so erhält man einen Wert zwischen 65 und 80%. Im radial äußeren Bereich (in Fig. 2 unten) liegt eine größere Hohlraumdichte vor, im radial inneren Bereich (in Fig. 2 oben) liegt eine kleinere Hohlraumdichte vor. Für einen Schnitt entlang der gekrümmten Mittelachse der Schaufel 1 wird somit eine mittlere Dichte von 65 bis 80% erreicht.

Auch kann man erkennen, dass an den Verzweigungsbereichen meist zwischen 3 und 5 Stützelementen 40, 41, 44 bis 54 zusammenlaufen.

Ein weiteres Mittel zur Charakterisierung der Struktur der Stützelemente 40, 41, 44 bis 54 ist die Anzahl der Verzweigungsbereiche in unterschiedlichen Richtungen der Schaufel 1. So können zwischen 0,1 und 5, insbesondere 0,1 bis 3, ganz insbesondere zwischen 0,1 bis 0,5 Verbindungsbereiche pro mm Lauflänge der Stützelemente (40, 41, 44-57) angeordnet sein.

Im Bereich der größten Dicke der Schaufel 1 können auf dem kürzesten Weg über die Stützelemente 40, 41, 44 bis 54 zwischen 2 und 20 Verbindungsbereiche durchlaufen werden. In einer anderen Richtung, nämlich von der Vorderkante zur Hinterkante können auf dem kürzesten Weg entlang der Stützelemente 40, 41, 44 bis 54 zwei bis 50 Verbindungsbereiche durchlaufen werden.

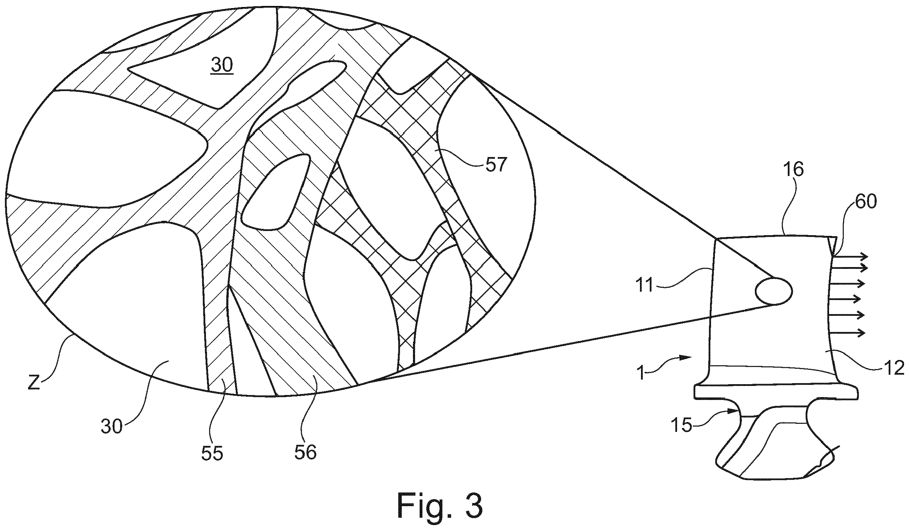

Die Figur 3 zeigt ein weiteres Ausführungsbeispiel einer Schaufel 1, die eine Schaufelinnenstruktur mit einer Mehrzahl von länglichen Stützelementen aufweist. Die Schaufel 1 weist ebenso wie die Schaufel der Figuren 1 und 2 eine Vorderkante 11, eine Hinterkante 12, eine Druckseite, eine Saugseite, einen Schaufelfuß 15 und eine Schaufelspitze 16 auf. Der Schaufelfuß 15 ist im Ausführungsbeispiel der Figur 3 als strukturelles Teil und nicht lediglich schematisch wie in der Figur 1 dargestellt.

Die vergrößerte Darstellung Z zeigt die Schaufelinnenstruktur beispielhaft in einer dreidimensionalen Darstellung, wobei drei unterschiedliche Ebenen des Raumes durch drei unterschiedliche Schraffierungen wiedergegeben sind. Es sind eine Vielzahl von länglichen Stützelementen 55, 56, 57 dargestellt, die eine sich verändernde Querschnittsfläche entlang ihres Verlaufes besitzen und zumindest abschnittsweise schräg zur radialen Richtung der Schaufel 1 sich erstrecken, wobei die Stützelemente 55, 56, 57 Verzweigungen, Abzweigungen und Zusammenschlüsse ausbilden und insgesamt ein dreidimensionales, asymmetrisches Gitter bilden. Die Bereiche zwischen den Stützelementen 55, 56, 57 sind wiederum als Hohlräume 30 ausgebildet sind.

Die Figur 3 verdeutlicht den dreidimensionalen, im Raum gekrümmten Verlauf der Stützelemente, die in den Figuren 1 und 2 jeweils nur in Schnittdarstellungen dargestellt sind.

Anhand der Figur 3 wird darüber hinaus auf einen weiteren, optionalen Aspekt hingewiesen. So kann vorgesehen sein, dass die Schaufelinnenstruktur Kanäle ausbildet, die dazu geeignet sind, Kühlluft zu transportieren. Solche Kanäle können in der beschriebenen Schaufelinnenstruktur durch länglich ausgebildete Hohlräume und/oder mehrere miteinander verbundene Hohlräume bereitgestellt werden. Hierdurch ist es möglich, die Schaufeln effektiv zu kühlen. Die Kühlluft kann beispielsweise über den Schaufelfuß 15 zugeführt werden. Dabei kann vorgesehen sein, dass ein oder mehrere der Hohlräume Kühlöffnungen in der Schaufelaußenhaut bilden. Solche Kühlöffnungen sind beispielsweise im Bereich der Schaufelhinterkante 12 ausgebildet. Beispielhafte Kühlöffnungen 60 sind in der Figur 3 schematisch dargestellt.

Es wird darauf hingewiesen, dass durch die Schaufelinnenstruktur auch ein Kühlen dünner Schaufeln, wie sie insbesondere bei Verdichtern Einsatz finden, ermöglicht wird.

Eine Schaufel mit einer Innenraumstrukturierung kann durch ein generatives Fertigungsverfahren, beispielsweise durch ein Laserschmelzverfahren (Laser Deposition) oder durch 3D-Drucken hergestellt werden. Zur Herstellung wird beispielsweise das folgende Verfahren eingesetzt.

Zunächst wird ein Vollmaterialmodell der Schaufel erstellt. Dieses Vollmaterialmodell wird mit einer hinreichenden Auflösung im Sinne eines Finite-Elemente-Verfahrens vernetzt. Anschließend erfolgt ein iteratives Entfernen von Materialbereichen des Vollmaterialmodells auf der Basis eines Finite-Elemente-Verfahrens. Dabei wird bei jeder Iteration mindestens ein Materialbereich des Vollmaterialmodells entfernt, der eine geringe Belastung beim Betrieb der Schaufel in einer Strömungsmaschine erfahren würde.

Hierzu werden gemäß einer Ausführungsform zwei Iterationsprozesse durchgeführt. Im Rahmen des ersten Iterationsprozesses werden zunächst Startbedingungen festgelegt. Ausgehend von festgelegten Startbedingungen erfolgt ein zweiter Iterationsprozess. Bei diesem werden Materialbereiche beliebiger Form und Größe an unterschiedlichen Positionen im Vollmaterialmodell gemäß den Startbedingungen entfernt. Anschließend werden die Belastungen des modifizierten Modells (d.h. des Modells nach Entfernen der Materialbereiche) im Betrieb der Schaufel bestimmt. Dies kann durch Simulationen ermittelt werden. Anschließend erfolgt ein Vergleich der resultierenden Belastungen mit gültigen Akzeptanzkriterien. Wenn die Akzeptanzkriterien erfüllt sind, erfolgt eine weitere Entfernung von Material und der Start einer neuen Iteration im Rahmen des zweiten Iterationsprozesses unter Verwendung des modifizierten Modells. Wenn die Akzeptanzkriterien nicht erfüllt sind, wird das Modell der letzten Iteration, die die diese Kriterien erfüllte, verwendet und es erfolgt eine Beendigung des zweiten Iterationsprozesses.

Anschließend erfolgt im Rahmen des ersten Iterationsprozesses eine Modifikation der Startbedingungen oder eine Festlegung neuer Startbedingungen für einen erneuten zweiten Iterationsprozess. Es wird dann einen Vergleich der Ergebnisse von mindestens zwei verschiedenen zweiten Iterationsprozessen durchgeführt. Der erste Iterationsprozess wird beendet, wenn vorbestimmte Bedingungen erreicht sind und/oder keine Verbesserung der Ergebnisse im Hinblick auf die Akzeptanzkriterien mehr erfolgt. Es wird dann eine 3D-Blaupause für das am Ende des zweiten Iterationsprozesses bereitgestellte Modell erzeugt. Anschließend erfolgt das Herstellen der Schaufel auf der Basis der erstellten 3D-Blaupause mittels eines generativen Fertigungsverfahrens.

Das beschriebene Verfahren führt zur Bereitstellung einer beanspruchungsgerechten Innenstruktur der Stützelemente der Schaufel. Die Querschnittsform- und -größe der Stützelemente ist dabei frei gemäß der Beanspruchung gerecht wählbar. Es wird eine vollständig beanspruchungsgerechte Konstruktion bereitgestellt, wobei die wenig belasteten Bereiche mittels des verwendeten Finite-Elemente-Verfahrens aus dem Vollmaterialmodell iterativ heraus gerechnet bzw. entfernt wurden.

Die bereitgestellte durchlässige Schaufelinnenstruktur kann zur Kühlung der Schaufel verwendet werden, wobei auch vorgesehen werden kann, dass Kühlöffnungen in der Schaufeloberfläche realisiert sind.

Die Erfindung beschränkt sich in ihrer Ausgestaltung nicht auf die vorstehend dargestellten Ausführungsbeispiele, die lediglich beispielhaft zu verstehen sind. So sind beispielsweise Form, Anzahl und Abmessungen der Stützelemente und der Hohlräume in den dargestellten Figuren lediglich als Beispiel zu verstehen.

Des Weiteren wird darauf hingewiesen, dass die Merkmale der einzelnen beschriebenen Ausführungsbeispiele der Erfindung in verschiedenen Kombinationen miteinander kombiniert werden können. Sofern Bereiche definiert sind, so umfassen diese sämtliche Werte innerhalb dieser Bereiche sowie sämtliche Teilbereiche, die in einen Bereich fallen.

Eine Schaufel, insbesondere nach einer der hier beschriebenen Ausführungsformen ist herstellbar nach einem der beanspruchten Verfahren.

## Patentansprüche

1. Schaufel (1) für eine Strömungsmaschine, die eine Schaufelaußenhaut (10) und eine Schaufelinnenstruktur (20) aufweist,
**dadurch gekennzeichnet, dass**
die Schaufelinnenstruktur (20) eine Mehrzahl von länglichen Stützelementen (40, 41, 44-57) aufweist, die sich zumindest abschnittsweise schräg zur radialen Richtung der Schaufel (1) erstrecken, wobei die Stützelemente (40, 41, 44-57) miteinander und/oder mit der Schaufelaußenhaut (10) verbunden und die Bereiche zwischen den Stützelementen (40, 41, 44-57) als Hohlräume (30-35) ausgebildet sind, wobei die Stützelemente (40, 41, 44-57) ein unregelmäßiges und asymmetrisches dreidimensionales Gitter bilden.

2. Schaufel nach Anspruch 1, **dadurch gekennzeichnet, dass** die Stützelemente (40, 41, 44-57) teilweise oder vollständig eine entlang ihres Verlaufs sich verändernde Querschnittsfläche aufweisen

3. Schaufel nach Anspruch 1 oder 2, **dadurch gekennzeichnet, dass** zumindest einige der Stützelemente (40, 41, 44-57) einen gebogenen Verlauf besitzen; die Stützelemente (40, 41, 44-57) zumindest abschnittsweise rippenartig ausgebildet sind und / oder die Stützelemente (41) zumindest abschnittsweise mindestens einen Steg bilden, der sich zwischen der Saugseite (16) und der Druckseite (15) der Schaufel (1) erstreckt.

4. Schaufel nach mindestens einem der vorangehenden Ansprüche, **dadurch gekennzeichnet, dass** zumindest zwei der Stützelemente sich in einem Verzweigungsbereich zu einem Stützelement vereinen und/oder mindestens ein Stützelement (47) sich in einem Verzweigungsbereich in zwei Stützelemente (48, 49) aufteilt, insbesondere dass an einem Verzweigungsbereich zwischen 3 und 100, insbesondere zwischen 3 und 50, ganz insbesondere zwischen 3 und 10 Stützelemente (40, 41, 44-57) zusammenlaufen, ferner insbesondere dass entlang der Stützelemente (40, 41, 44-57) zwischen 0,1 und 5, insbesondere 0,1 bis 3, ganz insbesondere zwischen 0,1 bis 0,5 Verbindungsbereiche pro mm Lauflänge der Stützelemente (40, 41, 44-57) angeordnet sind.

5. Schaufel nach mindestens einem der vorhergehenden Ansprüche, **dadurch gekennzeichnet, dass** die Laufrichtung der Stützelemente (40, 41, 44-57) als der kürzeste Weg von der Vorderkante der Schaufel (1) zur Hinterkante der Schaufel (1) oder als der kürzeste Weg von der Saugseite zur Druckseite der Schaufel (1) gemessen.

6. Schaufel nach mindestens einem der vorangehenden Ansprüche, **dadurch gekennzeichnet, dass** der mittlere Hohlraumanteil der Schaufelinnenstruktur (20) zwischen 65 und 80% beträgt, insbesondere zwischen 65 und 75%, ganz insbesondere 70%

7. Schaufel nach mindestens einem der vorangehenden Ansprüche, **dadurch gekennzeichnet, dass** mehrere der Stützelemente (51-54) sich zumindest abschnittsweise zu flächigen Wandbereichen (50) vereinigen, sich insbesondere zwischen 3 und 100, insbesondere 3 und 50, ganz insbesondere 3 und 10 Stützelemente (51-54) sich zumindest abschnittsweise zu flächigen Wandbereichen (50) vereinigen

8. Schaufel nach mindestens einem der vorangehenden Ansprüche, **dadurch gekennzeichnet, dass** die Stützelemente (40, 41, 44-57) eine Mehrzahl von Hohlräumen (30-35) definieren, wobei die Hohlräume (30-35) unterschiedliche Formen und Größen aufweisen, insbesondere dass die Hohlräume (30-35) eine unterschiedliche Größe derart aufweisen, dass in mindestens einer Schnittansicht der Schaufel (1) mindestens zwei Durchmesser der Hohlräume (30-35) sich um mindestens den Faktor 5 unterscheiden, insbesondere, dass mindestens zwei der Hohlräume (30-35) sich im Hinblick auf den Durchmesser um mindestens den Faktor 10, um mindestens den Faktor 20 oder um mindestens den Faktor 50 unterscheiden und / oder dass mindestens einer der Hohlräume (30-35) in der betrachteten Schnittansicht durch eine glatte und konvexe Begrenzungskurve begrenzt wird und / oder dass die Hohlräume in einer Schnittansicht senkrecht zur radialen Erstreckungsrichtung der Schaufel (1) und/oder in einer Schnittansicht senkrecht zur axialen Erstreckungsrichtung der Schaufel (1) und/oder in einer Schnittansicht senkrecht zur Umfangsrichtung der Schaufel (1) die genannten Durchmesser unterschiedlicher Größe aufweisen und / oder der Anteil der Hohlräume (30-35) am Gesamtvolumen der Schaufelinnenstruktur (20) in radialer Richtung nach außen zunimmt.

9. Schaufel nach mindestens einem der vorhergehenden Ansprüche, **dadurch gekennzeichnet, dass** keine zwei Stützelemente (40, 41, 44-57) der Schaufel (1) existieren, die eine identische dreidimensionale Form aufweisen.

10. Schaufel nach mindestens einem der vorhergehenden Ansprüche, **dadurch gekennzeichnet, dass** zumindest einige der Hohlräume (40, 41, 44-57) länglich ausgebildet und dazu geeignet sind, Kühlluft zu transportieren, und/oder mehrere Hohlräume (40, 41, 44-57) miteinander verbunden und insgesamt dazu geeignet sind, Kühlluft zu transportieren, insbesondere dass ein oder mehrere der Hohlräume Kühlöffnungen (60) in der Schaufelaußenhaut (10) bilden.

11. Schaufel nach mindestens einem der vorhergehenden Ansprüche, **dadurch gekennzeichnet, dass** Schaufelinnenstruktur (20) frei von Stützelementen (40, 41, 44-57) ist, die tangential zur Schaufelaußenhaut (10) und / oder stetig über die gesamte Schaufelaußenhaut (10) verlaufen und / oder dass sich zumindest einige der Stützelemente (40, 41, 44-57) einander durchdringen.

12. Turbofantriebwerk mit einer Mehrzahl von Schaufeln gemäß mindestens einem der Ansprüche 1 bis 11.

13. Verfahren zur Herstellung einer Schaufel nach Anspruch 1, **gekennzeichnet durch** die Schritte:
- Erstellen eines Vollmaterialmodells der Schaufel,
- iteratives Entfernen von Materialbereichen des Vollmaterialmodells auf der Basis eines Finite-Elemente-Verfahrens, wobei bei jeder Iteration mindestens ein Materialbereich des Vollmaterialmodells entfernt wird, der eine geringe Belastung beim Betrieb der Schaufel in einer Strömungsmaschine erfahren würde, wobei das iterative Verfahren bis zum Erreichen einer definierten Bedingung durchgeführt wird,
- Erstellen einer 3D-Blaupause des Modells, das bis Erreichen der definierten Bedingung **durch** das iterative Verfahren bereitgestellt worden ist, und
- Herstellen der Schaufel auf der Basis der erstellten 3D-Blaupause mittels eines generativen Fertigungsverfahrens.

14. Verfahren nach Anspruch 13, **dadurch gekennzeichnet, dass** bei jeder Iteration niedrigstbelastete Materialbereiche entfernt werden.

15. Verfahren nach Anspruch 13 oder 14, **dadurch gekennzeichnet, dass**
- nach Erstellen eines Vollmaterialmodells eine Vernetzung des Vollmaterialmodells mit definierter Auflösung bereitgestellt wird,
- im Rahmen eines ersten Iterationsprozesses Startbedingungen festgelegt werden,
- im Rahmen eines zweiten Iterationsprozesses
o Materialbereiche beliebiger Form und Größe an unterschiedlichen Positionen im Vollmaterialmodell gemäß den Startbedingungen entfernt werden,
o Belastungen des modifizierten Modelles im Betrieb bestimmt werden,
o ein Vergleich der resultierenden Belastungen mit gültigen Akzeptanzkriterien erfolgt,
o wenn die Akzeptanzkriterien erfüllt sind, eine weitere Entfernung von Material und der Start einer neuen Iteration unter Verwendung des modifizierten Modells erfolgt,
o wenn die Akzeptanzkriterien nicht erfüllt sind, das Modell der letzten Iteration, die diese Kriterien erfüllte, verwendet wird und eine Beendigung des zweiten Iterationsprozesses erfolgt,
- im Rahmen des ersten Iterationsprozesses eine Modifikation oder Festlegung neuer Startbedingungen für einen erneuten zweiten Iterationsprozess erfolgt,
- ein Vergleich der Ergebnisse von mindestens zwei verschiedenen zweiten Iterationsprozessen erfolgt,
- der erste Iterationsprozess beendet wird, wenn vorbestimmte Bedingungen erreicht sind und/oder keine Verbesserung der Ergebnisse im Hinblick auf die Akzeptanzkriterien mehr erfolgt, und
- eine 3D-Blaupause für das am Ende des zweiten Iterationsprozesses bereitgestellte Modell erstellt wird.
